Europäisches Patentamt

European Patent Office

Office européen des brevets

(11) Veröffentlichungsnummer: **0 442 312 A2**

## (12) EUROPÄISCHE PATENTANMELDUNG

(21) Anmeldenummer: 91101021.3

(22) Anmeldetag: 26.01.91

(51) Int. Cl.⁵: **G02B 6/42, H01L 31/12**

(30) Priorität: 10.02.90 DE 4004053

(43) Veröffentlichungstag der Anmeldung:
**21.08.91 Patentblatt 91/34**

(84) Benannte Vertragsstaaten:
**AT BE CH DE ES FR GB IT LI NL SE**

(71) Anmelder: **Standard Elektrik Lorenz
Aktiengesellschaft
Lorenzstrasse 10
W-7000 Stuttgart 40(DE)**
(84) **DE**

(71) Anmelder: **ALCATEL N.V.
Strawinskylaan 341 (World Trade Center)
NL-1077 XX Amsterdam(NL)**
(84) **BE CH ES FR GB IT LI NL SE AT**

(72) Erfinder: **Mozer, Albrecht, Dr.
Freibergerstrasse 30
W-7120 Bietigheim-Bissingen(DE)**

(74) Vertreter: **Pohl, Heribert, Dipl.-Ing et al
Standard Elektrik Lorenz AG Patent- und
Lizenzwesen Postfach 30 09 29
W-7000 Stuttgart 30(DE)**

(54) **Integrierter optischer Empfänger und/oder Sender.**

(57) Zum Umsetzen der Lichtsignale am Ende einer optischen Übertragungsstrecke in elektrische Signale als auch zur Erzeugung von optischen Signalen aus elektrischen Signalen sowie zur Signalaufbereitung innerhalb der Strecke sind opto-elektrische Empfängermodule, Sendermodule und opto-elektrische Zwischenverstärkermodule erforderlich. Diese sind üblicherweise in diskreter oder hybrider Technik aufgebaut.

Die Erfindung sieht vor, eine Vielzahl von Modulen (9) in monolitischer Integration auf einem für in Lichtwellenleiter geführtes Licht transparenten Halbleitersubstrat (4) anzuordnen. Die lichtempfindlichen und/oder lichtabgebenden Flächen der optischen Elemente (Fotodioden 10, Laserdioden) sind zur Substratoberfläche (6) gerichtet. In Ausrichtung auf die aktiven Flächen der Elemente (10) hat das Substrat (4) von der gegenüberliegenden Seite (5) her Sacklöcher (7), in denen Enden (3) von Lichtwellenleitern (2) geführt sind. Durch Verkleben (14) der Lichtwellenleiter (2) mit der Substratoberfläche (5) wird die Anordnung fixiert.

FIG.3

## INTEGRIERTER OPTISCHER EMPFÄNGER UND/ODER SENDER

Die Erfindung geht von einem optischen Empfänger und/oder Sender gemäß dem Oberbegriff des Anspruchs 1 aus.

Bei der Verwendung von Lichtwellenleitern als Übertragungsmedium sind am Anfang und am Ende der Strecke Sender- bzw. Empfängermodule angespleißt, durch die elektrische Signale in Lichtsignale und am Ende der Strecke wieder in elektrische Signale umgesetzt werden. Bei langen Übertragungsstrecken sind in gewissen Abständen Zwischenverstärkermodule zur Signalaufbereitung vorgesehen.

Die Module der vorgenannten Art werden bisher einzeln in diskreter oder hybrider Technik hergestellt. Sie befinden sich jeweils in einem Gehäuse, aus dem Lichtwellenleiter-Anschlußstücke und/oder Drahtanschlüsse herausragen. Derartige Module sind teuer und beanspruchen relativ viel Raum. Letzteres ist sehr hinderlich, wenn bei einer Vielzahl paralleler Lichtwellenleiter, z.B. im Fall eines Kabels, Sender- bzw. Empfängermodule oder Zwischenverstärkermodule an- bzw. eingespleißt werden sollen.

Die Aufgabe der Erfindung besteht darin, das Volumen der einzelnen Module und gleichzeitig die Herstellungskosten zu reduzieren.

Diese Aufgabe wird durch die im Anspruch 1 angegebenen Merkmale gelöst. Die Unteransprüche zeigen vorteilhafte Ausgestaltungen des Erfindungsgegenstandes auf.

Die durch die Erfindung erzielten Vorteile bestehen gemäß Anspruch 1 und 2 insbesondere darin, daß eine Vielzahl gleichartiger Module zu einem Zeilen- oder Flächenarray, vorzugsweise monolitisch integriert, auf kleinem Raum zusammengefaßt sind, daß die Anschlüsse alle in einer Ebene liegen, und daß die Lichtwellenleiterenden über Sacklöcher auf die lichtempfindlichen bzw. lichtabgebenden Elemente der Module ausgerichtet sind, so daß sich eine gesonderte zeit- und damit kostenaufwendige Justage erübrigt.

Anhand von zwei Ausführungsbeispielen wird die Erfindung in Verbindung mit den Zeichnungen nachfolgend näher erläutert. Es zeigt:

Fig. 1  ein erstes Ausführungsbeispiel eines Zeilenarrays mit monolitisch integrierten Empfängermodulen gemäß der Erfindung in schematischer Darstellung;

Fig. 2  die Schaltung eines Empfängermoduls, wie sie bei der Ausführung gem. Fig. 1 verwendet wird;

Fig. 3  eine Teildarstellung des Zeilenarrays gemäß Fig. 1 im Querschnitt und vergrößerten Maßstab;

Fig. 4  ein zweites Ausführungsbeispiel eines Zeilenarrays mit monolitisch integrierten Zwischenverstärkermodulen gemäß der Erfindung in schematischer Darstellung;

Fig. 5  die Schaltung eines Zwischenverstärkermoduls, wie sie bei der Ausführung gemäß Fig. 4 verwendet wird;

Fig. 6  eine Teildarstellung des Zeilenarrays gemäß Fig. 4 im Querschnitt und vergrößerten Maßstab.

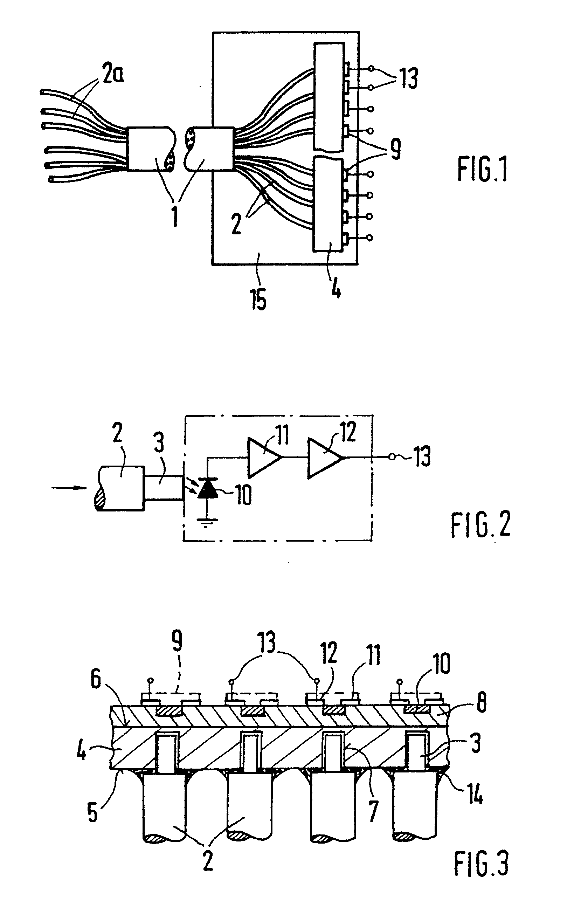

Die Figuren 1 bis 3 zeigen ein erstes Ausführungsbeispiel eines Zeilenarrays mit einer Vielzahl monolitisch integrierter Empfangsmodule 9.

Fig. 1 zeigt in schematischer Darstellung ein Zeilenarray mit einem Substrat 4 als Träger, das für das über Lichtwellenleiter geführte Licht aus einem transparenten Halbleitermaterial besteht. Auf der einen Oberfläche des Substrats 4 (Fig. 3, Pos. 6) ist eine Vielzahl monolitisch integrierter optischer Empfängermodule 9 in vorzugsweise gleichmäßigen Abständen angeordnet. An der anderen Oberfläche des Substrats 4 (Fig. 3, Pos. 5) sind in Ausrichtung auf lichtempfindliche Elemente, z.B. Fotodioden (Fig. 3, Pos. 10), der Module 9 rechtwinklig zur Substratoberfläche, Lichtwellenleiter 2 angeordnet. Die Lichtwellenleiter 2 sind Teil eines kurzen Kabelstücks 1. Bis auf elektrische Anschlußklemmen 13 der Empfängermodule 9 ist das Zeilenarray über das zum Array weisende Ende des Kabelstücks 1 zum Schutz und zur Zugentlastung in eine Vergußmasse 15 eingebettet. Das freie Ende des Kabelstücks 1 hat Lichtwellenleiteranschlußstücke 2a, über die die Empfängermodule 9 des Zeilenarrays in bekannter Weise an die Lichtwellenleiter einer Übertragungsstrecke angespleißt werden.

Fig. 2 zeigt die Schaltung eines Empfängermoduls 9, durch die die über die Lichtwellenleiter 2 zugeführten Lichtsignale am Ende einer Übertragungsstrecke in elektrische Signale umgesetzt werden. Ein Modul 9 besteht im wesentlichen aus einer Fotodiode 10, einem Vorverstärker 11 und einem Hauptverstärker 12, dessen Ausgang mit einer Ausgangsklemme 13 verbunden ist.

Fig. 3 zeigt im vergrößerten Maßstab und in schematischer Darstellung einen Teil des Zeilenarrays der Fig. 1 im Querschnitt. Das Substrat 4 ist gemäß der Darstellung mit vorzugsweise gleichmäßig beabstandeten Sacklöchern 7 versehen. Sie reichen bis dicht an die gegenüberliegende Oberfläche 6 des Substrats 4. Der Durchmesser der Sacklöcher 7 ist so gewählt, daß die Löcher 7 nach dem Aufdampfen eines nicht dargestellten Antireflexbelages eine im wesentlichen spielfreie Führung für die vom Schutzmantel befreiten Enden 3 der Lichtwellenleiter 2 bilden. Die Länge der Enden 3 ist gleich der Tiefe der Sacklöcher 7. Die mit der Stirnseite des Schutzmantels an der Substratoberfläche 5 anliegenden Lichtwellenleiter 2 werden in der dargestellten Lage durch Verkleben 14 mit der Oberfläche 5 fixiert. Auf der Oberfläche 6 des Substrats 4 sind z.B. in epitaktischen Schichten 8 Pin-Fotodioden 10 in Ausrichtung der lichtempfindlichen Flächen auf die Sacklöcher 7 eindiffundiert. Einzelheiten über derartige Fotodioden können der Schrift "Physikalische Blätter", Vol. 44 - No. 4 - April 88, Seiten 91 bis 97 entnommen werden. Die den Fotodioden 10 zugehörigen elektronischen Bauelemente 11 und 12 sind ebenfalls monolitisch integriert.

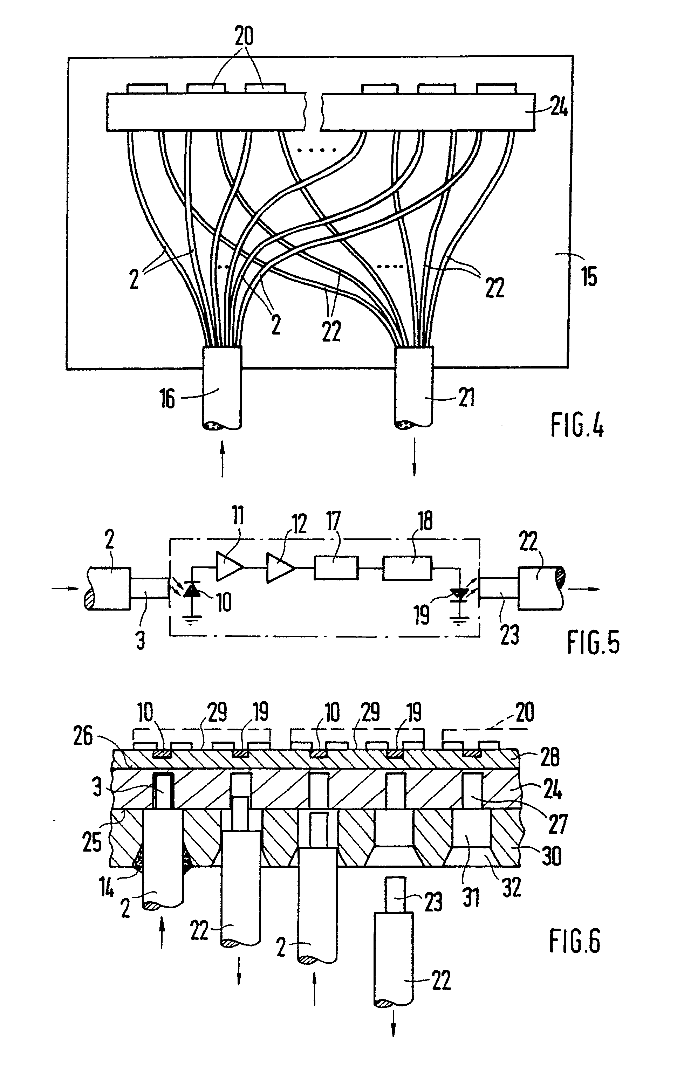

Die Figuren 4 bis 6 zeigen ein zweites Ausführungsbeispiel eines Zeilenarrays mit monolitisch integrierten Zwischenverstärkermodulen 20.

Fig. 4 zeigt - ähnlich dem vorbeschriebenen Beispiel - in schematischer Darstellung ein Zeilenarray mit einem Substrat 24 als Träger, der ebenfalls für das aus den Lichtwellenleitern austretende Licht aus einem transparenten Halbleitermaterial besteht. Auf der einen Seite des Substrats 24 ist eine Vielzahl monolitisch integrierter elektrischer Zwischenverstärkermodule 20 in vorzugsweise gleichmäßigen Abständen angeordnet. Auf der anderen Seite des Substrats 24 sind in Ausrichtung auf lichtempfindliche Elemente, z.B. Fotodioden (Fig. 6, Pos. 10) und lichtabgebende Elemente (Fig. 6, Pos. 19) der Module 20, Lichtwellenleiter 2 und 22 angeordnet. Die Lichtwellenleiter 2 und 22 gehören zu einem Übertragungskabel, das durch ein Einspleißen des Zeilenarrays in ein ankommendes Kabel 16 und ein abgehendes Kabel 21 unterteilt ist. Wie beim vorbeschriebenen Beispiel ist das angeschlossene Zeilenarray bis über die Enden der Kabel 16 und 21 in eine Vergußmasse eingebettet.

Fig. 5 zeigt die Schaltung eines Zwischenverstärkermoduls 20. Die über die Lichtwellenleiter 2 eintreffenden Lichtsignale werden in an sich bekannter Weise über eine Fotodiode 10 in elektrische Signale umgesetzt, in 11 und 12 verstärkt, in einem Regenerator 17 aufbereitet und über eine Treiberstufe 18 mit nachgeschalteter Laserdiode 19 als regeneriertes Lichtsignal über den jeweils angeschlossenen Lichtwellenleiter 22 wieder auf die Strecke gegeben.

Fig. 6 zeigt in vergrößertem Maßstab und in schematischer Darstellung einen Teil des Zeilenarrays der Fig. 4 im Querschnitt. Wie beim vorhergehenden Beispiel ist das Substrat 24 mit vorzugsweise gleichmäßig beabstandeten Sacklöchern 27 versehen. Sie sind in der vorbeschriebenen Weise ausgebildet. Auf der Oberfläche 26 des Substrats 24 sind z.B. in epitaktische Schichte 28 in Ausrichtung auf die Sacklöcher 27 Pin-Fotodioden 10 und Laserdioden 19 eindiffundiert. Die lichtabgebende Fläche einer Laserdiode 19 ist in zentrischer Ausrichtung auf das zugehörige Sackloch 27 zum Substrat gerichtet. Derartige Laser sind als sogenannte Short Cavity LD oder Surface Emitting Injuction Laser bekannt und im Konferenz-Programm der Ninth IEEE International Semiconductor Laser Conference, August 7-10, 1984, Seiten 52 und 53 zusammenfassend beschrieben. Die zur Signalaufbereitung genannten elektronischen Bauelemente 11, 12, 17 und 18 sind ebenfalls monolitisch integriert und über Leiterbahnen 29 miteinander verbunden.

Während beim ersten Ausführungsbeispiel das Zeilenarray konfektionierte Anschlüsse hat, sieht das zweite Ausführungsbeispiel einen direkten Anschluß der Lichtwellenleiter 2 bzw. 22 vor. Um das Einführen der vom Schutzmantel befreiten Lichtwellenleiterenden 3 bzw. 23 in die Sachlöcher 27 zu erleichtern, ist auf der Substratoberfläche 25 eine Lochmaske 30 mit Führungslöchern 31 angeordnet. Zum leichteren Einführen der Lichtwellenleiter 2 und 22 haben die Führungslöcher 31 nach außen hin eine trichterförmige Aufweitung 32. Die Lochmaske 30 ist so dick, daß der eingeführte Lichtwellenleiter 2 bzw. 22 bereits im Loch 31 geführt wird, bevor das Lichtwellenleiterende 3 bzw. 23 in das zugehörige Sackloch 27 eintritt. Die gestaffelte Anordnung der Lichtwellenleiter 2 und 22 in Fig. 6 veranschaulicht das Vorhergesagte. Die auf Anschlag eingeführten Lichtwellenleiter 2 und 22 werden durch Verkleben 14 mit der Lochmaske 30 fixiert.

Hat ein Kabel eine größere Anzahl Lichtwellenleiter, so kann die erforderliche Anzahl Module 9 bzw. 20 in Form eines Flächenarrays zusammengefaßt werden.

**Patentansprüche**

1. Optischer Empfänger und/oder Sender mit einem Substrat, auf dem sich mindestens ein lichtempfindliches und/oder lichtabgebendes Element befindet,
**dadurch gekennzeichnet,** daß die lichtempfindliche und/oder lichtabgebende Fläche des/der Elemente (Fotodiode 10, Laserdiode 19) zum Substrat (4, 24) weist, und daß das Substrat (4, 24) so ausgebildet ist, daß Lichtwellenleiter (2, 22) durch das Substrat (4, 24) hindurch an die Elemente (10, 19) angekoppelt sind oder ankoppelbar sind.

2. Optischer Empfänger und/oder Sender nach Anspruch 1, dadurch gekennzeichnet, daß das Substrat (4, 24) aus einem für in Lichtwellenleitern geführtes Licht transparenten Halbleitermaterial besteht, daß die lichtempfindlichen und/oder lichtabgebenden Elemente (10, 19) und die Signalverarbeitungselektronik auf der einen Seite (6) des Substrats (4, 24) angeordnet sind und daß das Substrat (4, 24) in Ausrichtung auf die Elemente (10, 19) auf der anderen Seite (5) Sacklöcher (7, 27) zur Aufnahme der Lichtwellenleiterenden (3, 23) hat.

3. Optischer Empfänger und/oder Sender nach Anspruch 2, dadurch gekennzeichnet, daß die Lichtwellenleiterenden (3, 23) durch Verkleben (14) der Lichtwellenleiter (2, 22) mit einem Träger (Substrat 5, Lochmaske 30) in den Sacklöchern (7) fixiert sind oder werden.

4. Optischer Empfänger und/oder Sender nach Anspruch 2, dadurch gekennzeichnet, daß die lichtempfindlichen und/oder lichtabgebenden Elemente (10, 19) in epitaktischen und/oder diffundierten Schichten (8, 28) auf dem Substrat (4, 24) angeordnet sind, und daß die zum jeweiligen Empfänger bzw. Sender gehörenden elektronischen Bauelemente (11, 12, 17, 18) monolitisch integriert sind.

5. Optischer Empfänger und/oder Sender nach Anspruch 2, dadurch gekennzeichnet, daß die Sacklöcher (7, 27) einen Antireflexbelag haben.

FIG.1

FIG.2

FIG.3

FIG.4

FIG.5

FIG.6